# EUROPÄISCHE PATENTSCHRIFT

(11) **EP 3 564 587 B1**
(45) Veröffentlichungstag und Bekanntmachung des Hinweises auf die Patenterteilung: **17.03.2021**
(21) Anmeldenummer: 19171098.7
(22) Anmeldetag: 25.04.2019
(51) Int. Cl.: F24C 7/08, H03K 17/97, G05G 5/06, H03K 17/00, G05G 1/08, H01H 19/02, G05G 1/10, A47L 15/42, D06F 34/30

(54) **BEDIENEINRICHTUNG FÜR EIN ELEKTROGERÄT UND ELEKTROGERÄT**
OPERATING DEVICE FOR AN ELECTRICAL DEVICE AND ELECTRICAL DEVICE
DISPOSITIF DE COMMANDE POUR UN APPAREIL ÉLECTRIQUE ET APPAREIL ÉLECTRIQUE

(30) Priorität: 03.05.2018 DE 102018206807
(43) Veröffentlichungstag der Anmeldung: 06.11.2019
(73) Patentinhaber: E.G.O. Elektro-Gerätebau GmbH, 75038 Oberderdingen (DE)
(72) Erfinder: Zarcone, Carmelo, 75015 Bretten (DE); Thimm, Dr. Wolfgang, 76137 Karlsruhe (DE); Ose, Dr. Lutz, 75447 Sternenfels (DE)
(74) Vertreter: Patentanwälte Ruff, Wilhelm, Beier, Dauster & Partner mbB

(56) Entgegenhaltungen:
- EP-A2- 1 775 650
- EP-A2- 2 251 762
- DE-A1- 10 218 294
- DE-A1-102011 002 410
- DE-B3-102010 017 992
- US-A1- 2016 181 028

## Beschreibung

### Anwendungsgebiet und Stand der Technik

Die Erfindung betrifft eine Bedieneinrichtung für ein Elektrogerät sowie ein mit einer solchen Bedieneinrichtung versehenes Elektrogerät. Insbesondere ist das Elektrogerät ein Kochfeld.

Aus der DE 10 2010 010 574 A1 ist allgemein eine Bedienvorrichtung bekannt, die insbesondere für ein Fahrzeug ausgelegt ist. Sie weist an einer Bedienblende ein bewegbares Bedienelement auf, und durch Drehung erfolgt eine Bedienung, insbesondere eine Einstellung.

Aus der DE 10 2011 007 463 A1 ist eine weitere Bedieneinrichtung bekannt, die für ein Haushaltsgerät wie beispielsweise ein Kochfeld ausgelegt ist. Hier kann ein drehbares Bedienelement abgenommen werden, wobei es durch Magnetkraft gehalten ist.

Aus der DE 10 2010 042 146 A1 ist eine weitere Bedieneinrichtung für ein Kochfeld bekannt, welche ein drehbares und abnehmbares Bedienelement aufweist. Es ist in einem Mittelbereich lichtdurchlässig bzw. offen ausgebildet. Dort ist eine Linse angeordnet, um eine darunter angezeigte Ziffer vergrößert darstellen zu können.

Aus der DE 10 2011 002 410 A1 ist eine Bedieneinrichtung für ein Elektrogerät bekannt mit einem Drehknebel, der magnetisch gehaltert ist, aber abnehmbar auf einer Bedienblende des Elektrogeräts aufliegt. An seiner Unterseite verlaufen nahe einem Außenrand ein ringförmiger Vorsprung und eine Vielzahl von Vorsprüngen entlang eines Rings. Sie liegen in einer ringförmigen entsprechenden Nut auf der Oberseite der Bedienblende an als Drehführung.

Aus der EP 2 251 762 A2 ist eine Bedienvorrichtung für ein Elektrogerät bekannt mit einem abnehmbar gehaltenen Drehknebel. Der Drehknebel ist an der Bedienblende magnetisch gehaltert und zentriert für eine Drehbewegung zur Bedienung. Eine Oberseite des Drehknebels ist lichtdurchlässig und weist eine darunter angeordnete Anzeige auf, um Informationen anzuzeigen.

Aus der EP 1 775 650 A2 ist eine weitere Bedienvorrichtung für ein Elektrogerät bekannt mit einem magnetisch gehalterten und abnehmbaren Drehknebel. Der Drehknebel weist an der Oberseite und/oder an der Lateralseite kapazitive Sensorelemente auf, deren Signale kapazitiv durch die Bedienblende hindurch an eine Steuerung darunter übertragen werden. So ist eine vielfältige Bedienung möglich.

Aus der US 2016/181028 A1 ist eine Bedieneinrichtung für ein Elektrogerät bekannt mit einem beleuchteten Bedienelement. Ein Lichtleiter ist dabei von unten durch eine mechanische Drehachse des Drehknebels geführt und überträgt Licht nach oben in den Drehknebel. An diesem kann es dann an unterschiedlichen Stellen nach außen austreten bzw. eine sichtbare Leuchterscheinung bewirken.

Aus der DE 10 2010 017 992 B3 ist eine nochmals weitere Bedieneinrichtung für ein Elektrogerät bekannt mit einem beleuchtbaren Drehknebel. Im Drehknebel sind voneinander getrennte Lichtkammern vorgesehen, in die Licht von unten eingestrahlt wird und die dann Buchstaben an einer Oberseite beleuchten können.

### Aufgabe und Lösung

Der Erfindung liegt die Aufgabe zugrunde, eine eingangs genannte Bedieneinrichtung sowie ein damit versehenes Elektrogerät zu schaffen, mit denen Probleme des Standes der Technik gelöst werden können und insbesondere eine Leuchtanzeige an einem bewegbaren Bedienelement der Bedieneinrichtung gut dargestellt werden kann mit überschaubarem Aufwand und in praxistauglicher robuster Ausgestaltung.

Gelöst wird diese Aufgabe durch eine Bedieneinrichtung mit den Merkmalen des Anspruchs 1 sowie durch ein Elektrogerät mit den Merkmalen des Anspruchs 13. Vorteilhafte sowie bevorzugte Ausgestaltungen der Erfindung sind in den weiteren Ansprüchen enthalten und werden im Folgenden näher erläutert. Dabei werden manche der Merkmale nur für die Bedieneinrichtung oder nur für das Elektrogerät beschrieben. Sie sollen jedoch unabhängig davon sowohl für die Bedieneinrichtung als auch für das Elektrogerät unabhängig und selbständig voneinander gelten können. Der Wortlaut der Ansprüche wird durch ausdrückliche Bezugnahme zum Inhalt der Beschreibung gemacht.

Es ist vorgesehen, dass die Bedieneinrichtung eine flächige Bedienblende aufweist, die geschlossen und zumindest bereichsweise lichtdurchlässig ist. Sie weist auch Leuchtmittel unterhalb der Bedienblende auf, um die Bedienblende von unten zu durchleuchten zum Erzeugen einer Leuchtanzeige, die von oben sichtbar ist. Des Weiteren weist sie mindestens einen Halte-Magnet unterhalb der Bedienblende auf. Dieser dient zum Halten eines bewegbaren Bedienelements, das an der Vorderseite der Bedienblende gegenüber dem Leuchtmittel und gegenüber dem mindestens einen Halte-Magnet bewegbar angeordnet ist, so dass es magnetisch gehaltert ist. Für diese magnetische Halterung weist die Bedieneinrichtung mindestens einen Gegen-Magnet im oder am Bedienelement zum Zusammenwirken mit dem mindestens einen Halte-Magnet durch anziehende Magnetkraft auf. Dies ist derart ausgebildet, dass das Bedienelement bei einer Bewegung zum Bedienen bzw. einer Bedien-Bewegung geführt ist durch eine anziehende Magnetkraft zwischen Halte-Magnet und Gegen-Magnet. So wird das Bedienelement an der Bedienblende gehalten und ist gleichzeitig aber noch bewegbar in einer Ebene parallel zur Oberfläche der Bedienblende, insbesondere verschiebbar und/oder drehbar. Anstelle von Halte-Magnet und Gegen-Magnet aus üblichem magnetischem Material könnte hier auch magnetisierbares Material verwendet werden, insbesondere Teile aus Eisen. Das andere Teil ist dann ein entsprechender Magnet, so dass die beiden Teile miteinander eine ausreichende anziehende Magnetkraft für eine stabile Halterung entwickeln können. Schließlich sind noch Sensormittel an bzw. unterhalb der Bedienblende vorgesehen, vorteilhaft gegenüber dem Bedienelement, die dazu ausgebildet sind, eine Position bzw. eine Drehstellung oder Drehposition des Bedienelements zu erfassen.

Erfindungsgemäß ist das Bedienelement lichtdurchlässig in bzw. entlang einer Richtung, die von den Leuchtmitteln zu dem Bedienelement verläuft. Insbesondere ist das Bedienelement lichtdurchlässig zwischen einer Unterseite und einer Oberseite bzw. einer Außenseite. Dafür weist das Bedienelement vorteilhaft mehrere lichtdurchlässige Bereiche auf, und diese Bereiche sind gegeneinander abgetrennt oder voneinander getrennt. Zwischen diesen Bereichen findet keine Übertragung von Licht statt, zumindest zwischen manchen dieser Bereiche nicht. Dadurch ist es möglich, dass die Bereiche beispielsweise eine bestimmte Form haben oder ein bestimmtes Licht in sie eingestrahlt wird und nur dieses dann von oben an dem Bedienelement sichtbar ist.

Dadurch, dass die Leuchtmittel unterhalb der Bedienblende angeordnet sind, ebenso auch die Sensormittel, ist es möglich, das Bedienelement ohne eigene Energieversorgung und ohne eigene aktive Bauelemente zu gestalten. Dadurch ist es einfach in der Handhabung und robust sowie langlebig. Dies ermöglicht es vorteilhaft, das Bedienelement unter diesen Aspekten auszugestalten. Gleichzeitig kann es aber hinsichtlich Erkennung der Bewegung und Anzeige von Informationen mittels der Leuchtanzeige viele vorteilhafte Möglichkeiten bieten.

In weiterer Ausgestaltung der Erfindung ist es möglich, dass die lichtdurchlässigen Bereiche des Bedienelements in einem Mittelbereich des Bedienelements vorgesehen sind. Sie können einen Abstand zu dem Außenrand des Bedienelements aufweisen. Dieser Abstand kann zwischen 5 % und 30 % des Durchmessers des Bedienelements betragen, möglicherweise zwischen 8 % und 20 % des Durchmessers. So kann der besonders gut sichtbare Mittelbereich des Bedienelements, selbst wenn es im Außenbereich oder am Außenrand gegriffen wird zur Bedienung, gut sichtbar sein. Damit können die entsprechenden Informationen bzw. Leuchtanzeigen stets gut erkannt werden.

Vorteilhaft ist die Bedieneinrichtung dazu ausgebildet, dass die Bedienbewegung eine Drehung des Bedienelements ist. Es ist zwar auch eine Schiebebewegung oder lineare Bewegung möglich. Eine Drehung wird jedoch als vorteilhaft angesehen, da sie üblichen Drehbewegungen wie beispielsweise bei Kochfeldern oder Herden entspricht. Des Weiteren ist der Platzbedarf für eine Drehung als Bedienbewegung erheblich geringer als für ein Verschieben. Auch die Ausgestaltung der Magnete zur magnetischen Halterung des Bedienelements an der Bedienblende ist einfacher, sie können beispielsweise an einer Stelle angeordnet sein oder nahezu punktuell vorgesehen sein.

In weiterer Ausgestaltung der Erfindung ist es möglich, dass die lichtdurchlässigen Bereiche im Bedienelement symmetrisch oder gleichmäßig ausgebildet sind. Insbesondere können sie rotationssymmetrisch ausgebildet sein bei einem kreisrunden oder rotationssymmetrischen Bedienelement. Alternativ können verschiedene lichtdurchlässige Bereiche auch rotationssymmetrisch angeordnet sein. Dadurch ist es möglich, dass bei einer mit einer Drehrasterung versehenen Drehbewegung des Bedienelements, beispielsweise mit Drehwinkeln von 20° bis 45° oder sogar bis 60°, sechs bis achtzehn im Kreis gleich verteilte lichtdurchlässige Bereiche angeordnet sind bzw. die lichtdurchlässigen Bereiche so angeordnet sind, dass bei jeder zweiten oder noch besser bei jeder Drehstellung, die eingerastet ist, eine Bedienperson dieselbe Anordnung von lichtdurchlässigen Bereichen sieht, nur dass es eben jeweils abwechselnd andere lichtdurchlässige Bereiche sind. So kann eine Leuchtanzeige von unterhalb des Bedienelements in jeder einzelnen Rastposition oder jeder zweiten der Rastpositionen für eine Bedienperson von oben genau gleich aussehen. Dies weist den Vorteil auf, dass die Bedienperson die Leuchtanzeige dann jeweils unabhängig von einer Drehposition des Bedienelements gut und einfach erkennen und verstehen kann.

In weiterer Ausgestaltung der Erfindung ist es möglich, dass der mindestens eine Halte-Magnet direkt an der Unterseite der Bedienblende anliegt und/oder befestigt ist, beispielsweise angedrückt ist oder festgeklebt ist. Vorteilhaft sind mehrere Halte-Magnete unterhalb der Bedienblende angeordnet, besonders vorteilhaft in ringförmiger Anordnung bzw. entlang eines Rings, insbesondere entlang eines Kreisrings. Dadurch kann auch eine Drehlagerung für das Bedienelement erreicht werden. Gleichzeitig kann auf zentrale Magnete verzichtet werden sowohl unter der Bedienblende als auch im Bedienelement, was es möglich macht, dass hier in dem Zentrum eben die genannten lichtdurchlässigen Bereiche vorgesehen sind für eine Darstellung einer Leuchtanzeige oben am Bedienelement bzw. an dessen Oberseite.

Es können mehrere Halte-Magnete und mehrere Gegen-Magnete vorgesehen sein, zwischen denen die Bedienblende angeordnet ist bzw. verläuft. Vorteilhaft sind die Halte-Magnete und die Gegen-Magnete korrespondierend zueinander angeordnet. Dies kann derart sein, dass jedem Halte-Magnet ein Gegen-Magnet gegenüberliegt, und zwar zumindest in einer Position bzw. Drehstellung, vorteilhaft in mehreren oder sogar während einer gesamten Drehung oder Bewegung des Bedienelements. Die Halte-Magnete und die Gegen-Magnete können derart zu ihren jeweils benachbarten Magneten versetzt sein, möglicherweise auch zumindest teilweise gegenpolig ausgebildet sein, dass sie gleichzeitig die eingangs genannte Drehrasterung oder Rasterung für eine Bewegung des Bedienelements bilden. Dies ist aber grundsätzlich aus dem Stand der Technik bekannt.

Es ist an sich ebenso bekannt und dennoch vorteilhaft für die Erfindung, wenn die Sensormittel als magnetische Sensormittel ausgebildet sind, vorzugsweise bieten sich Hall-Sensoren an. So kann besonders gut eine Position oder Bewegung des mindestens einen Gegen-Magnets erfasst werden, alternativ können die magnetischen Sensormittel auch die Bewegung von anderen bzw. ganz speziell vorgesehenen Magneten erfassen.

In vorteilhafter Ausgestaltung der Erfindung kann das Bedienelement eine in sich geschlossene und in sich unbewegbare bzw. nicht in sich bewegliche Baueinheit sein. So kann sie als ein Teil ausgebildet sein. Dies erleichtert die Handhabung und verbessert die Reinhaltung des Bedienelements, was gerade bei einer Anwendung der Bedieneinrichtung in einem Elektrokochgerät wie einem Kochfeld odgl. wichtig ist. So kann auch verhindert werden, dass Flüssigkeiten oder störende Stoffe in das Bedienelement eindringen können und möglicherweise zur Beeinträchtigung von dessen Funktion führen können. Das Bedienelement kann beispielsweise verklebt sein aus mehreren Bauteilen, alternativ kann es vergossen sein. Es kann auch zumindest teilweise durch ein Mehrkomponenten-Spritzgießen hergestellt sein. Ebenso ist es möglich, das Bedienelement aus mehreren Bauteilen zu fertigen, die miteinander verschraubt sind. Auch dadurch sind ein fester Zusammenhalt sowie eine mögliche Dichtheit erreichbar.

Das Bedienelement kann vorteilhaft zumindest teilweise durch 3D-Drucken hergestellt werden. Besonders vorteilhaft können die lichtdurchlässigen Bereiche auch durch 3D-Drucken hergestellt werden, was beispielsweise auch für Linsen und Lichtleiter möglich ist. So können ähnlich einem vorgenannten Mehrkomponenten-Spritzgießen unterschiedliche Materialien mit unterschiedlichen Aufgaben bzw. Funktionen fest zusammengefügt werden. Dies erleichtert die Herstellung und verbessert die mechanische Festigkeit.

In einer alternativen Ausgestaltung der Erfindung kann das Bedienelement mehrteilig ausgebildet sein, so dass es in sich beweglich ist. Es kann also gegeneinander bewegbare Bauteile aufweisen, die auch gewollt bzw. gezielt gegeneinander bewegbar sind. Eine solche Bewegbarkeit gegeneinander kann beispielsweise bei einem Bedienvorgang genutzt werden, wobei ein Teil des Bedienelements unbewegt bleibt, beispielsweise mit der Bedienblende verbunden ist oder fest daran gehalten wird. Demgegenüber kann ein anderer Teil des Bedienelements bewegt werden, und diese Bewegung kann beispielsweise als Bedienbewegung ausgewertet und verwendet werden. Ein Bauteil kann dabei ein Auflage-Halter sein, der eben auf die Oberseite der Bedienblende aufgelegt oder aufgesetzt wird. Er kann dort gehalten werden, vorteilhaft rutschfest durch hohe Oberflächenreibung aufgrund entsprechender Materialwahl an einer Unterseite des Auflage-Halters und mittels der eingangs genannten magnetischen Halterung. So wird der Auflage-Halter ortsfest gehalten, kann aber bei entsprechendem Kraftaufwand abgenommen werden.

Ein anderer Bauteil ist relativ zu dem beschriebenen Auflage-Halter drehbar beweglich und bildet vorteilhaft einen Drehknebel. Dies weist den Vorteil auf, dass die magnetische Halterung keinen Bewegungsgrad ermöglichen muss, sondern der Auflage-Halter einfach nur fest gehalten wird, was durch die vorgenannte rutschfeste Beschichtung verbessert werden kann. Die Realisierung der Drehbewegung, möglicherweise auch einer entsprechenden Rasterung oder Stufung, kann dann unabhängig von Magnetkraft oder Magneten erreicht werden durch das Vorsehen entsprechender konstruktiver Mittel zwischen Auflage-Halter und Drehknebel. Dann müssen auch keine Teile einer Rasteinrichtung an der Bedienblende vorgesehen sein.

Eine rutschfeste oder rutschhemmende Unterseite des Auflage-Halters kann beispielsweise durch Silikon erreicht werden. Dies weist den zusätzlichen Vorteil auf, dass die Unterseite dann temperaturbeständig ist, und gerade auch bei Verwendung der Bedieneinrichtung an einem Kochfeld als Elektrogerät Temperaturprobleme weniger kritisch sind. Des Weiteren kann Silikon sehr gut gereinigt werden und behält so die rutschhemmenden Eigenschaften. Insbesondere kann die Unterseite entlang eines Außenumfangs rutschfest oder rutschhemmend ausgebildet sein, beispielsweise mit einer flachen Beschichtung mit Silikon.

Alternativ zu einem Kochfeld kann es ein wasserführendes Haushaltsgerät sein mit einem vorderen Bereich als Vorderfront, die die Bedienblende für die Bedieneinrichtung bildet. So kann es vorteilhaft eine Waschmaschine, ein Wäschetrockner, ein Waschtrockner als Kombigerät oder eine Geschirrspülmaschine sein.

Ein vorgenannter Auflage-Halter kann ringförmig ausgebildet sein und einen freien Mittelbereich aufweisen. Alternativ kann der Mittelbereich lichtdurchlässig ausgebildet sein für die Leuchtanzeige bzw. das Durchstrahlen der Leuchtmittel. Eine Breite eines solchen ringförmigen Auflage-Halters, also des umlaufenden Rings, kann zwischen 5 % und 20 % des Durchmessers des gesamten Bedienelements betragen. Der Auflage-Halter kann seitlich über den demgegenüber drehbar beweglichen Drehknebel etwas überstehen, so dass der Drehknebel von außen her bzw. an seiner radialen Außenseite gehalten und geführt ist, was eine besonders sichere und präzise Führung ermöglicht. Zusätzlich kann hier auch eine vorgenannte Rasterung bzw. Rasteinrichtung vorgesehen sein. Für eine solche Rasteinrichtung sind bevorzugt mechanische Rastelemente zwischen Auflage-Halter und Drehknebel angeordnet. Diese können an sich auf bekannte Art und Weise ausgebildet sein, beispielsweise mit Vorsprüngen und/oder Ausnehmungen, die gegeneinander bewegt oder verdreht werden und dabei ineinandergreifen und einander ausweichen für die Rasterung. Dabei können beispielsweise auch die Vorsprünge elastisch oder federelastisch sein. An sich sind derartige Rasteinrichtungen aber bekannt.

Des Weiteren kann der Drehknebel für eine gute Bedienbarkeit bzw. Griffigkeit höher als der Auflage-Halter sein, so dass er mit den Fingern außen gegriffen werden kann und diese nicht den Auflage-Halter berühren oder aus Versehen versucht wird, diesen mitzudrehen. Eine Höhe von 2 bis 5 mm über der Ebene der Bedienblende wird als vorteilhaftes Maximum für den Auflage-Halter angesehen. Es ist auch möglich, dass der Drehknebel in seinem Außenbereich bzw. mit einem Außenrand oder einem Außenmantel mindestens 5 mm den Auflage-Halter überragt, vorteilhaft 8 mm bis 20 mm. Dann kann der Drehknebel gut gegriffen und gedreht werden.

Selbst bei einer Aufteilung des Bedienelements in einen Auflage-Halter und einen demgegenüber drehbar beweglichen Drehknebel kann die Rasteinrichtung auch magnetisch ausgebildet sein. Dazu kann sie, ähnlich wie zuvor beschrieben, anziehende und abstoßende Magnete aufweisen. Auch dies ist an sich aus dem Stand der Technik bekannt.

Vorteilhaft kann der Drehknebel derart aus dem Auflage-Halter entnehmbar oder von diesem entfernbar sein, dass dies eine Bewegung in einer Richtung weg von der Bedienblende ist. Insbesondere kann diese Bewegung senkrecht zur Bedienblende sein. Dadurch kann erreicht werden, dass eine seitliche Führung bzw. eine Führung gegen eine seitliche Relativbewegung der beiden Teile gegeneinander vorgesehen ist. So ist der Drehknebel auch gut und praxistauglich an dem Auflage-Halter gehaltert oder gelagert.

Bei der Erfindung sind die lichtdurchlässigen Bereiche des Bedienelements durch eine Vielzahl von Lichtleitern gebildet, beispielsweise mehr als zehn Lichtleiter, insbesondere mehr als zwanzig Lichtleiter oder sogar mehr als fünfzig Lichtleiter. Diese Lichtleiter liegen parallel und aneinander an innerhalb des Bedienelements. Sie sind so angeordnet, dass sie parallel zueinander ausgerichtet sind. Neben vorgenannten möglichen lichtdurchlässigen Bereichen in Form von Teilen mit einem speziellen Querschnitt, beispielsweise Kreisringsegmente, alternativ dreieckige, viereckige oder rechteckige Querschnitte, kann es auch sein, dass die Lichtleiter dünne Lichtleiterfasern sind. Ein Durchmesser kann maximal 3 mm betragen, insbesondere maximal 1 mm. So können die Lichtleiter vorteilhaft sozusagen als normale Lichtleiter ausgebildet sein, wie sie beispielsweise zur Datenübertragung verwendet werden. Wenn mit derartigen relativ dünnen Lichtleitern ein dickes Bündel gebildet wird bzw. eine große Anzahl verwendet wird, beispielsweise mit einer Fläche von 2 cm² bis zu 10 cm², so sind mehrere Hundert Lichtleiter im Bedienelement vorgesehen und diese sind dementsprechend lichtdurchlässig. Der Vorteil dieser Ausgestaltung des lichtdurchlässigen Bereichs bzw. der lichtdurchlässigen Bereiche des Bedienelements liegt darin, dass sozusagen eine sehr scharfe Abbildung einer von unten eingestrahlten Leuchtanzeige oder Leuchterscheinung möglich ist. Es erfolgt eigentlich keinerlei Verzerrung. Des Weiteren kann sogar der Effekt einer Anzeige genutzt werden, die sozusagen pixelig bzw. in Pixel aufgeteilt und durch Pixel dargestellt erscheint. Dadurch wird eine optisch besonders reizvolle Leuchtanzeige geschaffen. Des Weiteren kann durch eine derart große Anzahl von Lichtleitern oder lichtdurchlässigen Bereichen erreicht werden, dass eine Leuchtanzeige unterhalb der Bedienblende feststeht und sie auch bei sich drehendem Bedienelement bzw. Drehknebel an dessen Oberseite sozusagen feststehend scheint bzw. aussieht. Dadurch kann erreicht werden, dass die Leuchtanzeige stets gut erkennbar und stets lesbar bzw. verständlich ist.

In nochmals weiterer Ausgestaltung der Erfindung kann vorgesehen sein, dass mehrere vorgenannte lichtdurchlässige Bereiche oder Lichtleiter in ihrer Längserstreckung weg von der Bedienblende, insbesondere im Wesentlichen senkrecht dazu, ihre Querschnittsfläche ändern. Insbesondere können sie ihre Querschnittsfläche vergrößern. Dadurch kann eine Art Lupen- oder Vergrößerungs-Effekt erreicht werden, eine relativ kleine Leuchtanzeige unterhalb der Bedienblende kann an der Oberseite des Bedienelements oder des Drehknebels größer scheinen, möglicherweise sogar deutlich größer bzw. um mindestens 50 % größer.

Werden die lichtdurchlässigen Bereiche des Bedienelements durch Lichtleiter gebildet, aber nicht durch dünne Lichtleiterfasern, wie zuvor erläutert, sondern durch einzelne Teile, die beispielsweise eine Querschnittsfläche von mehr als 2 mm² oder sogar mehr als 4 mm² und bis zu 49 mm² haben, so können diese als einzelne separate Teile ausgebildet sein. Sie können dann zusammengefügt werden, beispielsweise verklebt werden. Zwischen ihnen sollten aber lichtundurchlässige Bereiche gebildet sein oder ihre Außenseiten sollten zumindest derart bearbeitet sein, dass kein Licht in seitlicher Richtung von einem lichtdurchlässigen Bereich in den anderen benachbarten lichtdurchlässigen Bereich eingestrahlt wird.

In weiterer Ausgestaltung der Erfindung ist es möglich, an dem vorgenannten Auflage-Halter mindestens einen lichtdurchlässigen Bereich vorzusehen, insbesondere einen Lichtleiter. Dieser kann relativ klein sein, alternativ kann er sich zumindest teilweise entlang der Ringform des Auflage-Halters erstrecken, besonders vorteilhaft ganz umlaufen als ringförmiger Lichtleiter. Damit kann eine zweite Leuchtanzeige oder Beleuchtung geschaffen werden unabhängig von der zuvor genannten hauptsächlichen Leuchtanzeige mittels der eingangs genannten Leuchtmittel. So kann beispielsweise angezeigt werden, dass das entsprechende Bedienelement von der Bedieneinrichtung vorgesehen ist für eine Betätigung, beispielsweise weil es zuvor selektiert worden ist auf an sich bekannte Art und Weise.

Licht kann in einen vorgenannten Lichtleiter auch von einem Leuchtmittel unterhalb der Bedienblende eingestrahlt werden. Vorteilhaft sind hierzu mehrere Leuchtmittel vorgesehen unterhalb der Bedienblende für eine gleichmäßige und starke Beleuchtung.

Die Strahlung der Leuchtmittel kann dabei gleichmäßig oder gepulst gesteuert werden. Kurze Pulse mit sehr hoher Intensität können dabei als gleichmäßiges Erscheinungsbild wahrgenommen werden entsprechend einem kontinuierlichen Leuchten. Die Leuchtmittel können dabei auch die Lichtstärke und/oder ihre Farbe ändern. Es ist im Rahmen der Erfindung möglich, die Pulsart und/oder die Lichtintensität bzw. Farbe in Abhängigkeit des Vorhandenseins des Bedienelements und/oder der Stellung des Bedienelements zu ändern. Neben der Änderung der Intensität bzw. Pulsdauer der Dioden ist es auch möglich, die Farben und Erscheinungen durch einen an sich bekannten MEMS Spiegel, der sich schnell bewegt, zu steuern.

In einer ersten weiteren Ausgestaltung der Erfindung leuchtet Licht von den Leuchtmitteln nach oben durch das Bedienelement bzw. durch die lichtdurchlässigen Bereiche direkt hindurch, es wird dabei möglicherweise umgelenkt, gebündelt oder aufgeweitet. Dabei ist es aber immer noch das gleiche Licht.

In einer zweiten anderen Ausgestaltung der Erfindung leuchtet Licht von den Leuchtmitteln in das Bedienelement hinein, und zwar in einen vorgenannten lichtdurchlässigen Bereich. Dieser kann ein Lichtleiter bzw. lichtdurchlässig sein. Vor allem aber regt das Licht der Leuchtmittel, das vorteilhaft UV-Licht sein kann und somit für eine Bedienperson unsichtbar ist, in dem lichtdurchlässigen Bereich bzw. Lichtleiter die Bildung von Licht mit einer anderen Wellenlänge an, nämlich im sichtbaren Wellenlängenbereich. Dieses sichtbare und sozusagen umgewandelte Licht wird dann von dem lichtdurchlässigen Bereich auf vorbeschriebene Art und Weise nach oben weiter geleitet bzw. ist von oben für eine Bedienperson sichtbar wie ansonsten auch bei direkter Durchleuchtung. Auch die Unterteilung in mehrere lichtdurchlässige Bereiche ist so möglich, wobei sie auch einzeln angestrahlt bzw. angeregt werden können. Damit sind dieselben Anzeigemöglichkeiten gegeben wie auch bei direkter Durchleuchtung, wie sie vorstehend beschrieben wurde. Nur der direkt sichtbare Leuchteffekt wird eben anders erzeugt, es ist also sozusagen anderes Licht.

Derartiges Material für den lichtdurchlässigen Bereich ist als UV-stimulierbares Material aus der DE 102015212915 A1 bekannt, auf die diesbezüglich ausdrücklich verwiesen wird. Das Leuchtmittel kann vorteilhaft eine entsprechende UV-LED sein.

Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schrägansicht auf ein Bedienelement einer erfindungsgemäßen Bedieneinrichtung mit mehreren lichtdurchlässigen Bereichen entlang konzentrischer Ringe,
- Fig. 2: eine erfindungsgemäße Bedieneinrichtung mit einem alternativ ausgebildeten Bedienelement samt ringförmig außen umlaufend angeordneten Halte-Magneten und Gegen-Magneten,
- Fig. 3: eine Draufsicht auf einen Teil einer weiteren erfindungsgemäßen Bedieneinrichtung mit ringförmig außen angeordneten Halte-Magneten, einer mittig angeordneten Flächenanzeige,
- Fig. 4: eine Darstellung eines nicht zur Erfindung gehörenden weiteren Bedienelements für die Bedieneinrichtung aus Fig. 3 bestehend aus mehreren zusammengesetzten Teilen in Explosionsdarstellung dieser Teile sowie in zusammengebauter Darstellung, wobei ein Mittelbereich völlig frei ist,
- Fig. 5: eine Draufsicht auf eine Abwandlung der Bedieneinrichtung aus Fig. 3 mit zwei ringförmigen Anordnungen von Halte-Magneten nebeneinander und einem großflächigen, verbindenden Display als Flächenanzeige,
- Fig. 6: eine Abwandlung der Bedieneinrichtung aus Fig. 5 und
- Fig. 7: eine nochmals weitere Ausgestaltung eines erfindungsgemäßen Bedienelements mit einem umlaufenden Außenring, in dessen Mittelbereich eine große Anzahl von parallelen Lichtleitern als Bündel angeordnet ist.

### Detaillierte Beschreibung der Ausführungsbeispiele

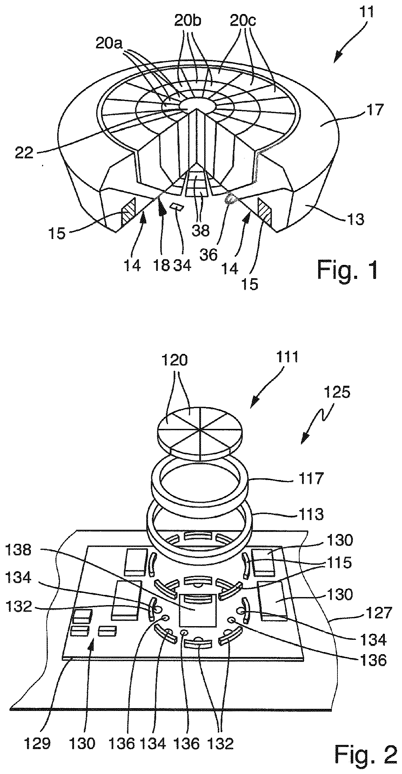

In der Fig. 1 ist ein erfindungsgemäßes Bedienelement für eine Bedieneinrichtung gemäß der Erfindung in Schrägdarstellung gezeigt. Das Bedienelement 11 ist nach Art eines eingangs genannten Bedienknebels ausgebildet als sogenannter Drehknebel, es wird insbesondere auf die EP 2 444 736 A2 verwiesen. Das Bedienelement 11 weist, wie der Teilschnitt zeigt, einen außen umlaufenden Basisring 13 auf. Dieser kann aus Kunststoff bestehen, alternativ aus nichtmagnetisierbarem Material wie Aluminium. Der Basisring 13 weist eine Unterseite 14 auf, mit der das Bedienelement 11 auf einer Oberseite einer hier nicht dargestellten Bedienblende aufgelegt sein kann, beispielsweise einer Glaskeramikplatte als Kochfeldplatte eines Kochfelds. In die Unterseite 14 sind in regelmäßigen Abständen, beispielsweise 10° bis 15° oder 0,5 cm bis 1 cm, Gegen-Magnete 15 eingelassen, vorteilhaft eingeklebt oder darin befestigt. Diese Gegen-Magnete 15 können in vertikaler Richtung gesehen rechteckigen Querschnitt aufweisen mit geringerer Breite in Umfangsrichtung als in radialer Richtung, alternativ können sie auch rund oder quadratisch sein im Querschnitt. Des Weiteren kann die Unterseite 14 noch mit einer Beschichtung versehen sein, die ein besonders leichtes Gleiten ermöglicht, beispielsweise aus PTFE.

Innerhalb des Basisrings 13 ist ein Leuchtring 17 angeordnet, der an die nach innen und nach oben weisende Anschrägung des Basisrings 13 genau angepasst ist. Der Leuchtring 17 ist lichtdurchlässig, vorteilhaft transluzent, und kann aus einem geeigneten Kunststoff bestehen. Der Leuchtring 17 weist eine schmale Unterseite 18 auf, die eine umlaufende Kreisringfläche mit geringer Breite in radialer Richtung bildet. Hier kann von darunter angeordneten LED 36, die unter einer nicht dargestellten Bedienblende angeordnet sind, Licht einstrahlen für eine optische Anzeige an einer Oberseite des Leuchtrings 17. Beispielsweise kann dies eine Orts-Information oder eine Kochstufenanzeige sein.

In der mittleren großen Öffnung des Leuchtrings 17 sind mehrere und unterschiedliche lichtdurchlässige Bereiche 20 angeordnet. Entlang eines innersten Bereichs sind lichtdurchlässige Bereiche 20a vorgesehen, und zwar dreizehn Stück. Außen daran anschließend sind mittlere lichtdurchlässige Bereiche 20b angeordnet, wiederum als Kreisringsegmente, allerdings etwas breiter, nämlich sechzehn Stück. Nochmals daran außen anschließend sind lichtdurchlässige Bereiche 20c vorgesehen, und zwar wiederum sechzehn Stück. Es ist zu erkennen, dass die Aufteilung in Umfangsrichtung zwischen den lichtdurchlässigen Bereichen 20b und 20c die gleiche ist, sie also jeweils die gleichen Winkelsegmente einnehmen mit einem Winkel von 22,5°.

Die lichtdurchlässigen Bereiche 20a, 20b und 20c sind, anders als das transluzente Material des Leuchtrings 17, möglichst lichtdurchlässig bzw. durchsichtig. Sie können leicht eingefärbt sein, um eine farbige Leuchterscheinung darzustellen, sollten aber eben möglichst viel Licht durchlassen für eine möglichst hohe Intensität der Leuchterscheinung. Dafür ist eine Flächenanzeige 38 darunter vorgesehen mit einzelnen LED, wobei die einzelnen LED vorteilhaft genauso angeordnet bzw. verteilt sind wie die lichtdurchlässigen Bereiche 20a, 20b und 20c in einer Drehstellung des Bedienelements 11. Dann sind die LED der Flächenanzeige 38 und die lichtdurchlässigen Bereiche 20a bis 20c vorteilhaft in Deckung.

Aus Platzgründen und der speziellen Konstruktion geschuldet, insbesondere wegen der unteren breiteren Basis an der Unterseite 14 des Basisrings 13, sind die äußeren lichtdurchlässigen Bereiche 20b und 20c ähnlich wie der Leuchtring 17 nach unten zu etwas nach innen gezogen und schmäler ausgebildet. Dies stört eine Lichteinstrahlung und Lichtleitung aber nicht.

Zentral in der Mitte, wo auch eine Drehachse des Bedienelements 11 verläuft, ist ein kapazitives Sensorelement 22 vorgesehen. Dieses besteht vorteilhaft aus elektrisch leitfähigem Material, beispielsweise Metall oder einem entsprechend mit Zusätzen vermischten Kunststoff. Unter der Bedienblende befindet sich unterhalb des kapazitiven Sensorelements 22 ein weiteres kapazitives Sensorelement, vorzugsweise eine elektrisch leitfähige Fläche, welche sozusagen das Auflegen eines Fingers auf die Oberseite des kapazitiven Sensorelements 22 mit kapazitiver Kopplung durch die Bedienblende hindurch an der Unterseite erkennen kann. Hierfür wird verwiesen auf die DE 10 2011 007 112 A1, die einen entsprechenden Gegenstand beschreibt, sowie auf die DE 10 2005 049 995 A1.

Das Bedienelement 11 kann auf seiner Oberseite auch noch eine Abdeckung aufweisen, beispielsweise lichtdurchlässig und als Lack bzw. Beschichtung, alternativ als Bauteil entsprechend einer Scheibe oder einer Kappe. Durch entsprechende Lichtdurchlässigkeit sind sämtliche Anzeigefunktionen dann weiterhin gegeben, und auch die Bedienfunktion mittels des kapazitiven Sensorelements 22 bleibt erhalten.

Des Weiteren ist in der Fig. 1 noch ein einzelner Hall-Sensor 34 dargestellt, der vorteilhaft auf demselben Bauteilträger wie die LED 36 und die Flächenanzeige 38 angeordnet ist. Der Hall-Sensor 34 ist, vorteilhaft zusammen mit weiteren Sensoren, auf einer Kreisbahn unterhalb der Gegen-Magnete 15 angeordnet, um deren Drehbewegung und somit eine Drehbewegung des Bedienelements 11 zu erfassen. Dies ist dem Fachmann ausreichend bekannt, hierzu wird auf den vorgenannten Stand der Technik verwiesen.

Auf diesem Bauteilträger sind vorteilhaft auch die hier nicht dargestellten Halte-Magnete für das Bedienelement 11 angeordnet.

In der Fig. 2 ist eine komplette erfindungsgemäße Bedieneinrichtung 125 dargestellt in schräger Explosionsdarstellung. Ein Bedienelement 111, welches ebenfalls im zusammengesetzten Zustand Scheibenform aufweist, weist einen außen umlaufenden Basisring 113 auf. In dessen Unterseite sind die acht bogenförmig ausgebildeten Gegen-Magnete 115 eingesetzt und verklebt. In dem Basisring 113 ist ein Leuchtring 117 angeordnet, vorteilhaft wiederum bestehend aus transluzentem Material. In der mittleren Öffnung des Leuchtrings 117 ist eine Scheibe mit acht lichtdurchlässigen Bereichen 120 vorgesehen, wobei diese lichtdurchlässigen Bereiche 120 optisch voneinander getrennt sind als Sektoren. Dies bedeutet, dass durch Beleuchtung eines einzelnen lichtdurchlässigen Bereichs 120 kein Licht in die benachbarten Bereiche eingestrahlt wird. Somit sind bei dem Bedienelement 111 acht in Sektoren unterteilte lichtdurchlässige Bereiche 120 vorgesehen, die hier gleich groß sind.

Das Bedienelement 111 wird im Anwendungsfall auf eine dargestellte Bedienblende 127 der Bedieneinrichtung 125 aufgelegt. Es wird gehalten sowie bei einer Drehung zentriert durch unter der Bedienblende 127 auf einer Leiterplatte 129 angeordnete Halte-Magnete 132, die eingangs beschrieben worden sind. Die Halte-Magnete 132 sind ausgebildet wie die Gegen-Magnete 115 und, wie die Darstellung zeigt, auch genau entsprechend angeordnet. Eine entsprechende Anordnung kann auch für das Bedienelement 11 in Fig. 1 vorgesehen sein. Auf der Leiterplatte 129 sind unterschiedliche Steuerbauteile 130 vorgesehen.

Durch die spezielle Anordnung der Halte-Magnete 132 und der Gegen-Magnete 115 ist eine Zentrierung bzw. genaue Führung des Bedienelements 111 bei dem Drehen bzw. bei einer Bedienung möglich ähnlich wie dies im Stand der Technik bekannt ist, insbesondere für die vorgenannte DE 10 2005 049 995 A1 oder die vorgenannte DE 10 2011 007 463 A1. Der mittlere Bereich bleibt dabei aber frei von Magneten.

Radial knapp innerhalb der Halte-Magnete 132 sind Hall-Sensoren 134 vorgesehen, die eine Veränderung des Magnetfelds beim Drehen des Bedienelements 111 erkennen und daraus die Drehbewegung erkennen und insbesondere analysieren können. Hierzu wird auf den Stand der Technik verwiesen bezüglich weiterer Details, insbesondere bezüglich Erkennung der Drehstellung.

Noch einmal etwas radial innerhalb der Hall-Sensoren 134 sind LED 136 auf der Leiterplatte 129 angeordnet, und zwar genau unterhalb des Leuchtrings 117. Durch eine variierende Aktivierung bzw. Beleuchtung verschiedener LED 136 kann, je nachdem wie weit ein beleuchteter Streifen am Leuchtring 117 umläuft, beispielsweise eine Kochstufe oder eine Art Timer-Ablauf angezeigt werden. Hier sind für den Fachmann vielfältige Möglichkeiten erkennbar und vorstellbar sowie leicht umsetzbar.

Innerhalb des Rings von Halte-Magneten 132 bzw. in einem Mittelbereich ist eine rechteckig ausgebildete Flächenanzeige 138 vorgesehen. Diese besteht vorteilhaft aus einer Matrix-artigen Anordnung von LED in Zeilen und Spalten, um verschiedene Anzeigemöglichkeiten zu bilden. Alternativ kann eine Flächenanzeige 138 auch aufgeteilt sein in winkelartige Sektoren ähnlich wie die lichtdurchlässigen Bereiche 120 selbst.

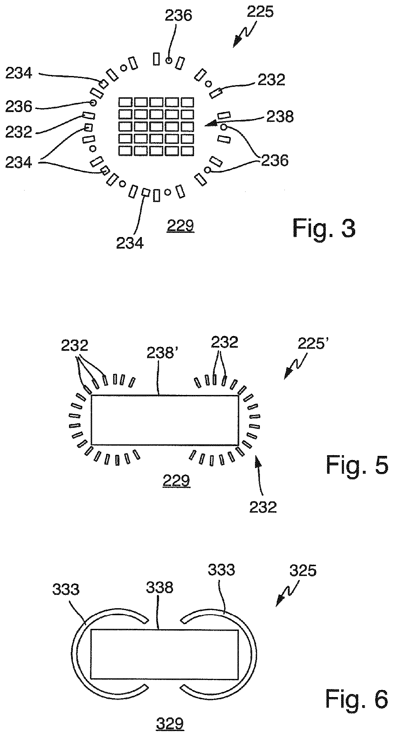

Die Anordnung von Halte-Magneten 132 und Gegen-Magneten 115 samt jeweiliger Polung mit anziehender Kraft ist vorteilhaft so, dass sich eine Art magnetische Rasterung ergibt. Dies bedeutet, dass das Bedienelement 111 immer automatisch in eine der Drehstellungen bewegt wird, in denen ein Gegen-Magnet 115 genau über einem Halte-Magnet 132 ist. Eine derartige magnetische Rasterung wird von einer Bedienperson als angenehm und vorteilhaft empfunden, da sie weitgehend einer mechanischen Rasterung entspricht hinsichtlich der Haptik und für eine präzisere Bedienung sowie eine gewisse haptische Rückmeldung an eine Bedienperson sorgt. In der Fig. 3 ist in Draufsicht ein Teil einer nochmals weiteren erfindungsgemäßen Bedieneinrichtung 225 unter einer Bedienblende dargestellt, und zwar derjenige Teil, der auf einer Leiterplatte 229 angeordnet ist. Hier fehlen die Steuerbauteile auf der Leiterplatte 229, diese sind aber leicht vorstellbar. Des Weiteren sind hier die Halte-Magnete 232 zwar auch kurz und länglich ausgebildet, allerdings in radialer Richtung verlaufend ausgebildet und nicht in Umfangsrichtung wie bei Fig. 2. Dies könnte also beispielsweise dem Bedienelement 11 aus Fig. 1 entsprechen. Zwischen den Halte-Magneten 232 sind mehrere Hall-Sensoren 234 angeordnet mit derselben Funktion wie zu Fig. 2 beschrieben, nur eben an etwas anderer Stelle.

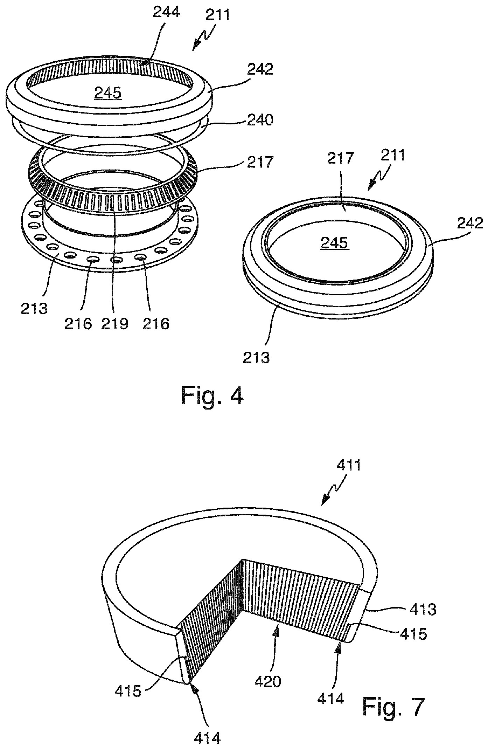

Des Weiteren sind zwischen den Halte-Magneten 232 LED 236 angeordnet, allerdings nur in jeder zweiten Lücke. Diese können in einen direkt darüber angeordneten Leuchtring einstrahlen, wie er nachfolgend in der Fig. 4 beschrieben wird.

In einem Mittelbereich befindet sich eine rechteckige Flächenanzeige 238 ähnlich derjenigen aus Fig. 2, und zwar mit fünf rechteckigen Einzelelementen. Insbesondere sind dies einzelne LED wie beispielsweise SMD-LED, mit jeweils fünf pro Zeile und pro Spalte.

Bei einem Kochfeld mit vier oder vor allem mit mehr als vier diskreten Kochstellen kann eine Flächenanzeige entsprechend der Fig. 3 auch dazu vorgesehen sein, durch Beleuchtung mehrerer der einzelnen LED oder Leuchtquellen anzuzeigen, an welcher Stelle ein Kochgefäß auf eine Kochfeldfläche aufgestellt ist, für welches mittels dem zu dieser Flächenanzeige 238 gehörenden Bedienelement eine Leistung zur Beheizung eingestellt ist. Somit kann das Bedienelement selbst einer Bedienperson auch gleich anzeigen, welche Bereiche an der Kochfeldfläche entsprechend einem aufgestellten Kochgefäß in seiner Leistung eingestellt werden. Die entsprechende Leistungsstufe kann dann durch den äußeren Ring bzw. Leuchtring am Bedienelement mittels der LED 236 anteilig angezeigt werden. Alternativ können hierfür auch nicht genutzte Leuchtelemente der Flächenanzeige 238 verwendet werden.

Das dazu passende aber nicht zur Erfindung gehörende Bedienelement 211 ist in Fig. 4 dargestellt, und zwar links in auseinandergezogener bzw. Explosionsdarstellung und rechts zusammengesetzt. Das Bedienelement 211 weist einen Basisring 213 auf, der geformt ist als eine Art ganz kurzer Rohrabschnitt oder breiter Ring mit nach außen abstehendem flachem Flansch. In diesem Flansch sind Löcher 216 angebracht, und zwar in einem Raster entsprechend den Halte-Magneten 232 bzw. in einem Raster, das doppelt so eng ist wie das der LED 236.

Die Hall-Sensoren 234 könnten zumindest teilweise auch derart in nicht-regelmäßigen Abständen in Umfangsrichtung angeordnet sein, dass sie nicht nur allgemein eine Drehbewegung eines Bedienelements darüber erkennen können über ein veränderndes Magnetfeld, sondern vor allem auch eine Drehrichtung bzw. Drehrichtungsänderung erkennen können. Dies ist dem Fachmann aber bekannt aus dem Stand der Technik.

Der Basisring 213 weist hier keine eigenen Magnete auf, insofern sollte er beispielsweise selbst aus magnetischem Material wie Eisen odgl. bestehen. Er kann an seiner Unterseite mit einer gut haftenden Beschichtung versehen sein, beispielsweise mit Silikon. Dadurch kann er, wenn er auf eine Bedienblende ähnlich Fig. 2 aufgesetzt ist, sozusagen haften und nur mit größerem Kraftaufwand auf der Bedienblende bzw. deren Fläche gedreht werden. Ein Abheben kann dagegen sehr leicht erfolgen, dazu muss nur die magnetische Anziehungskraft des eisernen Basisrings 213 gegenüber den Halte-Magneten 232 überwunden werden.

Auf den Basisring 213 ist ein Leuchtring 217 aufgesetzt aus transluzentem Material. Dieser ist im Querschnitt in etwa dreieckig ausgebildet mit einer breiten Basis, die sämtliche Löcher 216 überdeckt, damit von unten eingestrahltes Licht der LED 236 in den Leuchtring 217 einstrahlen kann.

An seiner schrägen nach außen weisenden Seite ist der Leuchtring 213 mit einer Art Rasterung 219 versehen in sehr feiner Abstufung. Diese weist eine Vielzahl kleiner rippenartiger Vorsprünge auf. Der Leuchtring ist vorteilhaft fest mit dem Basisring 213 verbunden, jedenfalls soll er gegenüber diesem nicht bewegbar sein.

Auf den Leuchtring 217 wird ein Außenring 242 aufgesetzt, beispielsweise bestehend aus Aluminium, alternativ aus Kunststoff. Der Außenring 242 weist an seiner Innenseite eine Innenrasterung 244 auf, die derart mit der Rasterung 219 des Leuchtrings 217 zusammenwirkt, dass eben bei Verdrehung der beiden Teile gegeneinander eine übliche Drehrasterung auf mechanische Art und Weise erreicht wird. Der Außenring 242 kann mit einem schmalen äußeren Ringbereich direkt auf dem Basisring 213 aufliegen. Zur Verminderung von Reibung kann hier ein schmaler Gleitring 240 vorgesehen sein.

Der Außenring 242 weist einen ausgenommenen und somit freien Mittelbereich 245 auf bzw. umgibt diesen. Somit ergibt sich das rechts in Fig. 4 dargestellte Bedienelement 211 als eine Art in sich beweglicher bzw. verdrehbarer Ring, bei dem der Basisring 213 magnetisch auf einer Bedienblende gehalten wird. Mittels einer mechanischen Rasterung kann der Außenring 242 gegenüber dem am Basisring 213 befestigten Leuchtring 217 gedreht werden mit einer feinen Drehrasterung. Der Leuchtring 217 ist dabei mit einem schmalen umlaufenden Ring an der Oberseite von oben zu sehen, so dass das Licht der LED 236 hier abschnittsweise hindurchleuchtet.

Insbesondere kann hier das Bedienelement 211 durch Magnetkraft gehalten werden. Es kann alternativ auch durch Magnetkraft zusammengepresst werden, wenn der Basisring 213 nicht magnetisch ist, sondern beispielsweise aus Aluminium oder aus Kunststoff besteht. Dann besteht der Außenring 242 aus magnetischem bzw. ferromagnetischem Material. Er wird von den Halte-Magneten 232 unter der Bedienblende nach unten gezogen und drückt so auch gegen den Basisring und diesen damit auf die Bedienblende. So halten die einzelnen Teile des Bedienelements 211 zusammen und so wird auch ein gewisser Anpressdruck auf den Basisring 213 ausgeübt, damit dieser sozusagen fest auf einer Oberseite der Bedienblende aufliegt. Der Basisring kann an seiner Unterseite eine rutschhemmende Fläche aufweisen. Für eine Verstärkung des Effekts des Zusammenhaltens können im Außenring 242 auch kleine, aber starke Magnete angeordnet sein zum Zusammenwirken mit den Halte-Magneten 232. Möglich ist dies entsprechend einem ganzteiligen oder geteilten Raster der Halte-Magnete 232, alternativ in ganz eigener Aufteilung. Derartige Magnete im drehbaren Basisring 213 können auch wiederum mittels der Hall-Sensoren 234 eine Drehbewegung besser erkennbar machen.

Durch den freien Mittelbereich 245 kann das Flächendisplay 238 gut erkannt werden bzw. ist frei sichtbar. Möglicherweise kann in dem freien Mittelbereich 245 auch eine Art lichtdurchlässige Scheibe oder Unterteilung ähnlich der Fig. 1 oder 2 vorgesehen sein, wobei diese dann am Leuchtring 217 vorgesehen sein können, alternativ aber auch am Außenring 242 oder am Basisring 213. Dieser freie Mittelbereich 245 bildet einen der erfindungsgemäßen lichtdurchlässigen Bereiche, ein anderer wird gebildet von dem davon getrennten Leuchtring 217. Somit weist dieses Bedienelement 211 immerhin zwei erfindungsgemäße lichtdurchlässige Bereiche auf.

In Fig. 5 ist angelehnt an die Bedieneinrichtung aus Fig. 3 eine weitere Bedieneinrichtung 225' dargestellt mit Halte-Magneten 232' ähnlich Fig. 3, nur in noch engerem Raster. Des Weiteren laufen diese Halte-Magnete 232' nicht vollständig um bzw. bilden keinen geschlossenen Kreis, sondern sind benachbart zueinander und in dieser Richtung sozusagen offen bzw. unterbrochen. Hier ist eine großflächige Flächenanzeige 238' vorgesehen, deren linker Bereich von einem linken Teil-Ring von Halte-Magneten 232' überdeckt ist bzw. von einem entsprechenden Bedienelement überdeckt wird, während ein rechter Bereich spiegelbildlich genauso ist. Auch durch diese nicht geschlossen umlaufende Anordnung der Halte-Magnete 232' ist eine Halterung und Zentrierung eines Bedienelements ähnlich Fig. 4 sehr gut möglich. Ebenso kann dessen Drehbewegung bzw. Drehbetätigung erkannt werden, insbesondere mittels geeigneter Hall-Sensoren. Damit können mit einer solchen Bedieneinrichtung 225' zwei Bedienelemente 211 entsprechend Fig. 4 relativ nahe nebeneinander platziert werden. Bei einer Anwendung in einem Kochfeld mit vier Kochstellen oder vier gewünschten Bedienelementen können dann zwei dieser Doppel-Anordnungen untereinander oder auch nebeneinander vorgesehen sein. Durch die großflächige Flächenanzeige 238' kann möglicherweise im Vergleich zu zwei kleineren Flächenanzeigen Anschlussaufwand eingespart werden. Ebenso kann im Mittelbereich zwischen den beiden Bedienelementen etwas angezeigt werden.

In der Fig. 6 ist eine nochmals weitere Bedieneinrichtung 325 dargestellt, welche auch eine längliche Flächenanzeige 338 aufweist ähnlich Fig. 5. Sie ist für zwei Bedienelemente ähnlich Fig. 4 ausgelegt, die nebeneinander angeordnet sind. In Abweichung von der Ausbildung der Fig. 5 ist hier pro Bedienelement ein einziger durchgängiger länglicher Magnet-Teilring 333 entsprechend einem vorgenannten Halte-Magnet vorgesehen. Dann kann entweder keine Rasterung vorgesehen sein, alternativ kann diese durch einzelne Gegen-Magnete am darüber angeordneten Bedienelement erreicht werden, wenn diese die Enden des Magnet-Teilrings 333 passieren. Ebenso kann eine Rasterung wie in Fig. 4 dargestellt innerhalb des Bedienelements vorgesehen werden. Bei dieser Bedieneinrichtung 325 sind keine LED oder Hall-Sensoren odgl. gezeigt, sie sind aber leicht vorstellbar.

Ein nochmals weiteres mögliches Bedienelement entsprechend der Erfindung ist in Fig. 7 dargestellt. Es ähnelt entfernt dem Bedienelement 11 aus Fig. 1. Das Bedienelement 411 weist einen außen umlaufenden Basisring 413 auf, vorteilhaft aus nicht-magnetischem und nichtmagnetisierbarem Material wie Kunststoff oder Aluminium. An einer Unterseite 414, die relativ schmal ist, sind in Umlaufrichtung verlaufende Gegen-Magnete 415 eingesetzt, ähnlich wie dies beim Bedienelement 111 der Fig. 2 der Fall ist. Es können beispielsweise acht, zwölf oder sechzehn Gegen-Magnete 415 sein. Die dazu passende Bedieneinrichtung weist, ähnlich wie in Fig. 2, entsprechend ausgebildete Halte-Magnete auf sowie Hall-Sensoren zur magnetischen Fixierung sowie zur Erkennung einer Drehbewegung.

Innerhalb das Basisrings 413 ist eine Vielzahl von in vertikaler Richtung verlaufenden Lichtleitern als lichtdurchlässige Bereiche 420 vorgesehen. Die Zahl kann sehr hoch sein, es kann auch beispielsweise ein Lichtleiter- oder Glasfaserbündel sein. So können es bis zu mehrere Hundert einzelne Lichtleiter sein als erfindungsgemäße lichtdurchlässige Bereiche, die insbesondere auch nicht zwingend geordnet oder in einem speziellen Raster angeordnet sein müssen. Sie sollten nur eng beieinander, bevorzugt sich direkt berührend, und vorteilhaft regelmäßig angeordnet sein, insbesondere gleiche Abmessungen haben. Wird dieses Bedienelement 411 an einer Bedieneinrichtung mit einer Flächenanzeige angeordnet, beispielsweise entsprechend der Fig. 2, 3, 5 oder 6, so übertragen die Lichtleiter der lichtdurchlässigen Bereiche 420 sozusagen die Leuchterscheinung von unten nach oben in fast genau gleichbleibender Form. An einer Oberseite des Bedienelements 411 ergibt sich somit eine Art gepixelte Darstellung mit einer Pixelgröße entsprechend der Querschnittsfläche der Lichtleiter. Dies kann sogar gewünscht reizvoll oder vorteilhaft sein.

## Patentansprüche

1. Bedieneinrichtung (125, 225, 325) für ein Elektrogerät, aufweisend:
- eine flächige Bedienblende (127), die geschlossen und zumindest bereichsweise lichtdurchlässig ist,
- Leuchtmittel (36, 38, 136, 138, 236, 238, 338) unterhalb der Bedienblende (127) zum Durchleuchten der Bedienblende von unten,
- mindestens einen Halte-Magnet (132, 232) unterhalb der Bedienblende,
- ein bewegbares Bedienelement (11, 111, 411), das an der Vorderseite der Bedienblende (127) gegenüber den Leuchtmitteln und dem mindestens einen Halte-Magnet bewegbar angeordnet ist, wobei das Bedienelement magnetisch gehaltert ist,
- mindestens einen Gegen-Magnet (15, 115, 415) im oder am Bedienelement (11, 111, 411) zum Zusammenwirken mit dem mindestens einen Halte-Magnet (132, 232) durch anziehende Magnetkraft derart, dass das Bedienelement bei einer Bewegung zum Bedienen geführt ist durch eine anziehende Magnetkraft zwischen Halte-Magnet (132, 232) und Gegen-Magnet (15, 115, 415), und derart, dass das Bedienelement an der Bedienblende (127) gehalten ist,
- Sensormittel (34, 134, 234) an bzw. unterhalb der Bedienblende (127), wobei die Sensormittel ausgebildet sind zur Erfassung einer Position bzw. Drehstellung des Bedienelements (11, 111, 411),
wobei das Bedienelement (11, 111, 411) lichtdurchlässig ist in einer Richtung, die von den Leuchtmitteln (36, 38, 136, 138, 236, 238, 338) zu dem Bedienelement verläuft, wobei dafür das Bedienelement mehrere lichtdurchlässige Bereiche (20, 120, 420) aufweist, die gegeneinander abgetrennt sind oder voneinander getrennt sind ohne Übertragung von Licht gegeneinander,
**dadurch gekennzeichnet, dass**
die lichtdurchlässigen Bereiche des Bedienelements (11, 111, 411) durch eine Vielzahl von Lichtleitern (20, 120, 420) gebildet sind, die parallel und aneinander anliegend innerhalb des Bedienelements angeordnet sind mit Ausrichtung parallel zueinander.

2. Bedieneinrichtung nach Anspruch 1, **dadurch gekennzeichnet, dass** die lichtdurchlässigen Bereiche (20, 120, 420) des Bedienelements (11, 111, 411) mindestens in einem Mittelbereich des Bedienelements vorgesehen sind mit einem Abstand zu einem Außenrand des Bedienelements, wobei vorzugsweise dieser Abstand zwischen 5% und 30% des Durchmessers des Bedienelements beträgt.

3. Bedieneinrichtung nach Anspruch 1 oder 2, **dadurch gekennzeichnet, dass** die Bedienbewegung eine Drehung des Bedienelements (11, 111, 411) ist.

4. Bedieneinrichtung nach einem der vorhergehenden Ansprüche, **dadurch gekennzeichnet, dass** die lichtdurchlässigen (20, 120, 420) Bereiche im Bedienelement (11, 111, 411) symmetrisch oder gleichmäßig ausgebildet sind, insbesondere rotationssymmetrisch bei einem kreisrunden oder rotationssymmetrischen Bedienelement.

5. Bedieneinrichtung nach einem der vorhergehenden Ansprüche, **dadurch gekennzeichnet, dass** die Lichtleiter als dünne Lichtleiterfasern (420) mit einem Durchmesser von maximal 3 mm ausgebildet sind.

6. Bedieneinrichtung nach einem der vorhergehenden Ansprüche, **dadurch gekennzeichnet, dass** die Lichtleiter (20a - 20c) in ihrer Längserstreckung weg von der Bedienblende (127), insbesondere im Wesentlichen senkrecht dazu, ihre Querschnittsfläche ändern, insbesondere vergrößern.

7. Bedieneinrichtung nach einem der vorhergehenden Ansprüche, **dadurch gekennzeichnet, dass** der mindestens eine Halte-Magnet (132, 232) direkt an der Unterseite der Bedienblende (127) anliegt und/oder befestigt ist, wobei insbesondere mehrere Halte-Magnete unterhalb der Bedienblende angeordnet sind, vorzugsweise in ringförmiger Anordnung bzw. entlang eines Rings.

8. Bedieneinrichtung nach einem der vorhergehenden Ansprüche, **dadurch gekennzeichnet, dass** mehrere Halte-Magnete (132, 232) und mehrere Gegen-Magnete (15, 115, 415) vorgesehen sind mit der Bedienblende (127) dazwischen, wobei sie korrespondierend zueinander angeordnet sind, wobei insbesondere jedem Halte-Magnet ein Gegen-Magnet gegenüberliegt.

9. Bedieneinrichtung nach einem der vorhergehenden Ansprüche, **dadurch gekennzeichnet, dass** die Sensormittel als magnetische Sensormittel ausgebildet sind, insbesondere als Hall-Sensoren (34, 134, 234), und eine Position oder Bewegung des mindestens einen Gegen-Magnet (15, 115, 415) erfassen.

10. Bedieneinrichtung nach einem der vorhergehenden Ansprüche, **dadurch gekennzeichnet, dass** das Bedienelement (11, 111, 411) eine in sich geschlossene und in sich unbewegbare Baueinheit ist und als ein Teil ausgebildet ist.

11. Bedieneinrichtung nach einem der Ansprüche 1 bis 9, **dadurch gekennzeichnet, dass** das Bedienelement mehrteilig ausgebildet ist und in sich beweglich ist bzw. gegeneinander bewegbare Bauteile aufweist, wobei vorzugsweise die Bauteile verdrehbar sind und ein Bauteil ein Auflage-Halter ist zum Auflegen auf die Oberseite der Bedienblende, so dass er dort ortsfest aber abnehmbar gehalten ist, und ein anderer Bauteil ein demgegenüber drehbar beweglicher Drehknebel ist, wobei insbesondere der Auflage-Halter ringförmig ausgebildet ist mit freiem Mittelbereich, wobei eine Breite des ringförmigen Auflage-Halters zwischen 5% und 20% des Durchmessers des Bedienelements beträgt.

12. Bedieneinrichtung nach Anspruch 11, **dadurch gekennzeichnet, dass** zwischen Auflage-Halter und Drehknebel eine Rasteinrichtung vorgesehen ist, wobei insbesondere die Rasteinrichtung mechanische Rastelemente zwischen Auflage-Halter und Drehknebel aufweist, vorzugsweise Vorsprünge und/oder Ausnehmungen.

13. Elektrogerät mit einer Bedieneinrichtung (125, 225, 325) nach einem der vorhergehenden Ansprüche.

14. Elektrogerät nach Anspruch 13, **dadurch gekennzeichnet, dass** es ein Kochfeld ist mit einer Kochfeldplatte und daran oder darunter angeordneten Heizeinrichtungen, wobei ein Teil der Kochfeldplatte, insbesondere ein vorderer Bereich, die Bedienblende (127) für die Bedieneinrichtung (125, 225, 325) bildet.

15. Elektrogerät nach Anspruch 13, **dadurch gekennzeichnet, dass** es ein wasserführendes Haushaltsgerät ist, insbesondere eine Waschmaschine, ein Wäschetrockner, ein Waschtrockner als Kombigerät oder eine Geschirrspülmaschine, mit einem vorderen Bereich als Vorderfront, die die Bedienblende (127) für die Bedieneinrichtung (125, 225, 325) bildet.

## Claims

1. Operating device (125, 225, 325) for an electrical device, having:
- a flat control panel (127) that is closed and at least regionally transparent,
- lighting means (36, 38, 136, 138, 236, 238, 338) underneath the control panel (127) in order to shine through the control panel from below,
- at least one holding magnet (132, 232) underneath the control panel,
- a movable operating element (11, 111, 411) that is arranged on the front side of the control panel (127) so as to be able to move with respect to the lighting means and with respect to the at least one holding magnet, wherein the operating element is held magnetically,
- at least one counter-magnet (15, 115, 415) in or on the operating element (11, 111, 411) for interacting with the at least one holding magnet (132, 232) through attractive magnetic force, such that the operating element, in the case of a movement for operation, is guided by an attractive magnetic force between the holding magnet (132, 232) and the counter-magnet (15, 115, 415), and such that the operating element is held on the control panel (127),
- sensor means (34, 134, 234) on or underneath the control panel (127), wherein the sensor means are designed to detect a position or a rotational position of the operating element (11, 111, 411),
wherein the operating element (11, 111, 411) is transparent in a direction that runs from the lighting means (36, 38, 136, 138, 236, 238, 338) to the operating element, wherein, for this purpose, the operating element has a plurality of transparent regions (20, 120, 420) that are partitioned against each other or separated from one another without transmitting light between each other,
**characterized in that**
the transparent regions of the operating element (11, 111, 411) are formed by a multiplicity of light guides (20, 120, 420) that are arranged in parallel and bearing against one another inside the operating element with an alignment parallel to one another.

2. Operating device according to claim 1, **characterized in that** the transparent regions (20, 120, 420) of the operating element (11, 111, 411) are provided at least in a central region of the operating element at a distance from an outer edge of the operating element, wherein this distance is preferably between 5% and 30% of the diameter of the operating element.

3. Operating device according to claim 1 or 2, **characterized in that** the operating movement is a rotation of the operating element (11, 111, 411).

4. Operating device according to any of the preceding claims, **characterized in that** the transparent regions (20, 120, 420) in the operating element (11, 111, 411) are designed so as to be symmetrical or uniform, in particular rotationally symmetrical in the case of a circular or rotationally symmetrical operating element.

5. Operating device according to any of the preceding claims, **characterized in that** the light guides are designed as thin optical fibres (420) with a diameter of a maximum of 3 mm.

6. Operating device according to any of the preceding claims, **characterized in that** the light guides (20a to 20c), in their longitudinal extent away from the control panel (127), in particular substantially perpendicular thereto, change, in particular increase, their cross-sectional area.

7. Operating device according to any of the preceding claims, **characterized in that** the at least one holding magnet (132, 232) bears and/or is fastened directly on the underside of the control panel (127), wherein in particular a plurality of holding magnets are arranged underneath the control panel, preferably in a ring-shaped arrangement or along a ring.

8. Operating device according to any of the preceding claims, **characterized in that** a plurality of holding magnets (132, 232) and a plurality of counter-magnets (15, 115, 415) are provided with the control panel (127) in between them, wherein they are arranged so as to correspond to one another, wherein in particular one counter-magnet lies opposite each holding magnet.

9. Operating device according to any of the preceding claims, **characterized in that** the sensor means are designed as magnetic sensor means, in particular as Hall sensors (34, 134, 234), and detect a position or movement of the at least one counter-magnet (15, 115, 415).

10. Operating device according to any of the preceding claims, **characterized in that** the operating element (11, 111, 411) is an intrinsically closed and intrinsically unmovable structural unit and is designed as one part.

11. Operating device according to any of claims 1 to 9, **characterized in that** the operating element is designed in several parts and is intrinsically movable or has components able to move with respect to one another, wherein the components are preferably rotatable and one component is a support holder to be placed on the upper side of the control panel, such that it is held fixed in terms of location or in a removable manner there, and another component is a rotary knob able to move rotationally with respect thereto, wherein in particular the support holder is designed so as to be ring-shaped with a free central region, wherein a width of the ring-shaped support holder is between 5% and 20% of the diameter of the operating element.

12. Operating device according to claim 11, **characterized in that** an engagement device is provided between support holder and rotary knob, wherein in particular the engagement device has mechanical engagement elements between support holder and rotary knob, preferably protrusions and/or recesses.

13. Electrical device having an operating device (125, 225, 325) according to one of the preceding claims.

14. Electrical device according to claim 13, **characterized in that** it is a hob having a hob plate and heating devices arranged thereon or underneath, wherein part of the hob plate, in particular a front region, forms the control panel (127) for the operating device (125, 225, 325).

15. Electrical device according to claim 13, **characterized in that** it is a household device that uses water, in particular a washing machine, a tumble dryer, a washer dryer as a combined device, or a dishwasher, having a front region as front that forms the control panel (127) for the operating device (125, 225, 325).

## Revendications

1. Dispositif de commande (125, 225, 325) pour un appareil électrique, comprenant :
- un panneau de commande plat (127) qui est fermé et translucide au moins dans certaines zones,
- moyens lumineux (36, 38, 136, 138, 236, 238, 338) en dessous du panneau de commande (127) pour luire à travers le panneau de commande par le bas,
- au moins un aimant de retenue (132, 232) en dessous du panneau de commande,
- un élément de commande mobile (11, 111, 411) disposé de façon déplaçable sur le côté frontal du panneau de commande (127 à l'opposé des moyens lumineux et l'au moins un aimant de retenue, l'élément de commande étant supporté magnétiquement,
- au moins un contre-aimant (15, 115, 415) dans ou sur l'élément de commande (11, 111, 411) pour coopérer avec l'au moins un aimant de retenue (132, 232) par force magnétique attractive de telle manière que l'élément de commande lors d'un déplacement pour commander est guidé par une force magnétique attractive entre aimant de retenue (132, 232) et contre-aimant (15, 115, 415), et de telle manière que l'élément de commande est retenu sur le panneau de commande (127),
- moyens capteurs (34, 134, 234) sur ou en dessous du panneau de commande (127), les moyens capteurs étant configurés pour détecter une position ou orientation de rotation de l'élément de commande (11, 111, 411),
dans lequel l'élément de commande (11, 111, 411) est translucide dans une direction s'étendant à partir des moyens lumineux (36, 38, 136, 138, 236, 238, 338) vers l'élément de commande, dans lequel à cette fin l'élément de commande présente plusieurs zones translucides (20, 120, 420), clôturées l'une contre l'autre ou séparées l'une de l'autre sans transmission de lumière entre eux,
**caractérisé en ce que**
les zones translucides de l'élément de commande (11, 111, 411) sont formées par une pluralité de conducteurs de lumière (20, 120, 420) disposés en parallèle et adjacents l'un à l'autre au sein de l'élément de commande présentant une orientation parallèle l'un à l'autre.

2. Dispositif de commande selon la revendication 1, **caractérisé en ce que** les zones translucides (20, 120, 420) de l'élément de commande (11, 111, 411) sont prévues au moins dans une zone centrale de l'élément de commande avec une distance à un bord extérieur de l'élément de commande, dans lequel de préférence cette distance est comprise entre 5 % et 30 % du diamètre de l'élément de commande.

3. Dispositif de commande selon la revendication 1 ou 2, **caractérisé en ce que** le déplacement de commande est une rotation de l'élément de commande (11, 111, 411).

4. Dispositif de commande selon l'une quelconque des revendications précédentes, **caractérisé en ce que** les zones translucides (20, 120, 420) dans l'élément de commande (11, 111, 411) sont sous forme symétrique ou uniforme, en particulier sous forme symétrique en rotation en cas d'un élément de commande circulaire ou de forme symétrique en rotation.

5. Dispositif de commande selon l'une quelconque des revendications précédentes, **caractérisé en ce que** les conducteurs de lumière sont sous forme de fibres optiques (420) minces présentant un diamètre de 3 mm au maximum.

6. Dispositif de commande selon l'une quelconque des revendications précédentes, **caractérisé en ce que** les conducteurs de lumière (20a à 20c) dans leur étendue longitudinale éloignée du panneau de commande (127), en particulier essentiellement perpendiculaire à celui-ci, changent de section transversale, en particulier augmentent.

7. Dispositif de commande selon l'une quelconque des revendications précédentes, **caractérisé en ce que** l'au moins un aimant de retenue (132, 232) reste et/ou est fixé directement sur le côté inférieur du panneau de commande (127), dans lequel en particulier plusieurs aimants de retenue sont disposés en dessous du panneau de commande, de préférence dans un agencement annulaire ou le long d'un anneau.

8. Dispositif de commande selon l'une quelconque des revendications précédentes, **caractérisé en ce que** plusieurs aimants de retenue (132, 232) et plusieurs contre-aimants (15, 115, 415) sont prévus avec le panneau de commande (127) interposé, dans lequel les aimants sont disposés en correspondance l'un à l'autre, dans lequel en particulier un contre-aimant est opposé à chaque aimant de retenue.

9. Dispositif de commande selon l'une quelconque des revendications précédentes, **caractérisé en ce que** les moyens capteurs sont configurés sous forme de moyens capteurs magnétiques, en particulier sous forme de capteurs Hall (34, 134, 234), et pour détecter une position ou un déplacement de l'au moins un contre-aimant (15, 115, 415).

10. Dispositif de commande selon l'une quelconque des revendications précédentes, **caractérisé en ce que** l'élément de commande (11, 111, 411) est sous forme d'unité physique fermée sur elle-même et immobile sur elle-même et formé en une partie.

11. Dispositif de commande selon l'une quelconque des revendications 1 à 9, **caractérisé en ce que** l'élément de commande est multi-composant et est mobile en soi-même ou présente des composants mobiles l'un par rapport à l'autre, dans lequel de préférence les composants sont tournables et un composant est un support portant pour placer sur le côté supérieur du panneau de commande pour ainsi retenir ledit support fixement mais amovible, et un autre composant est une manette rotative mobile en rotation par rapport à celui-ci, dans lequel en particulier le support portant est annulaire avec une zone centrale libre, dans lequel une largeur du support portant annulaire est comprise entre 5 % et 20 % du diamètre de l'élément de commande.

12. Dispositif de commande selon la revendication 11, **caractérisé en ce qu'**un dispositif d'encliquetage est prévu entre support portant et manette rotative, dans lequel en particulier le dispositif d'encliquetage présente des éléments d'encliquetage mécaniques entre support portant et manette rotative, de préférence des saillies et/ou évidements.

13. Appareil électrique comprenant un dispositif de commande (125, 225, 325) selon l'une quelconque des revendications précédentes.

14. Appareil électrique selon la revendication 13, **caractérisé en ce que** ledit appareil est une table de cuisson avec une plaque de table de cuisson et des dispositifs de chauffage disposés sur celle-ci ou en dessous, dans lequel une partie de la plaque de table de cuisson, en particulier une zone frontale, forme le panneau de commande (127) pour le dispositif de commande (125, 225, 325).

15. Appareil électrique selon la revendication 13, **caractérisé en ce que** ledit appareil est un appareil ménager utilisant de l'eau, en particulier une machine à laver, un sèche-linge, une machine à laver et à sécher sous forme d'unité combinée ou un lave-vaisselle, avec une zone frontale comme face visible formant le panneau de commande (127) pour le dispositif de commande (125, 225, 325).
